# EUROPEAN PATENT APPLICATION

(11) **EP 4 372 830 A1**
(43) Date of publication of application: **22.05.2024**
(21) Application number: 23209236.1
(22) Date of filing: 10.11.2023
(51) Int. Cl.: H01L 33/06, H01L 33/24, H01L 33/44, H01L 33/00, H01L 33/20, H01L 33/32, H01L 33/50, H01L 25/075

(54) **LIGHT EMITTING ELEMENT, DISPLAY DEVICE INCLUDING THE SAME, AND MANUFACTURING METHOD OF SAID LIGHT EMITTING ELEMENT**

(30) Priority: 15.11.2022 KR 20220152619
(71) Applicant: Samsung Display Co., Ltd., Yongin-si, Gyeonggi-do 17113 (KR)
(72) Inventor: LEE, Kwan Jae, 17113 Yongin-si (KR); PARK, Bong Chun, 17113 Yongin-si (KR); LEE, Dong Eon, 17113 Yongin-si (KR); LEE, So Young, 17113 Yongin-si (KR); LEE, Seung A, 17113 Yongin-si (KR)
(74) Representative: Taor, Simon Edward William

(57) **Abstract**

A light emitting element (LD) includes: a first semiconductor layer (11); an active layer (12) provided on the first semiconductor layer; a second semiconductor layer (13) provided on the active layer; and an insulative film (14) around at least a portion of the first semiconductor layer, the active layer, and the second semiconductor layer, which are sequentially provided in a first direction (DR1). The active layer (12) includes a first barrier layer (QB1), a first well layer (QW1), and a second barrier layer (QB2), which are sequentially provided in the first direction, and the first well layer (QW1) includes first holes (EH1) penetrating the first well layer. A method of manufacturing said light emitting element is also disclosed; method during which the well layer is partially etched in order to form the holes.

## Description

### CROSS-REFERENCE TO RELATED APPLICATION

This application claims priority to and the benefit of Korean patent application No. 10-2022-0152619 filed on November 15, 2022, in the Korean Intellectual Property Office.

### BACKGROUND

### 1. Field

One or more embodiments of the present disclosure generally relates to a light emitting element, a display device including the same, and a manufacturing method of a light emitting element.

### 2. Related Art

Recently, as interest in information displays is increased, research and development of display devices have been continuously conducted.

### SUMMARY

One or more embodiments of the present disclosure provide a light emitting element capable of improving reliability by preventing or reducing a decrease in luminance change rate of light emitted from the light emitting element.

One or more embodiments also provide a display device including the light emitting element and a manufacturing method of the light emitting element.

In accordance with one or more embodiments of the present disclosure, there is provided a light emitting element including: a first semiconductor layer; an active layer on the first semiconductor layer; a second semiconductor layer on the active layer, the first semiconductor layer, the active layer, and the second semiconductor layer being sequentially provided in a first direction; and an insulative film around at least a portion of the first semiconductor layer, the active layer, and the second semiconductor layer, wherein the active layer includes a first barrier layer, a first well layer, and a second barrier layer, which are sequentially provided in the first direction, and wherein the first well layer includes first holes penetrating the first well layer.

The first well layer may include at least one of GaN, GaInP, AIGalnP, InGaN, or InGaAsP.

The first well layer may include InₓGa₁₋ₓN, and an indium composition X of the first well layer may be 0.05 to 0.4.

The first holes may penetrate the first well layer in the first direction, and be provided in a second direction intersecting the first direction.

Each of the first holes may have a width that varies in the first direction.

When viewed in a plan view, each of the first holes may have a shape symmetrical in the second direction.

When viewed in a plan view, the first well layer may include a first area adjacent to a center of the first well layer and a second area adjacent to an edge of the first well layer. The first holes may be provided in the second area.

The second barrier layer may fill spaces formed by the first holes and the first barrier layer.

The light emitting element may further include a second well layer and a third barrier layer, which are sequentially provided in the first direction on the second barrier layer. The second well layer may include second holes penetrating the second well layer in the first direction.

The first well layer and the second well layer may include at least one of GaN, GaInP, AIGalnP, InGaN, or InGaAsP. The first well layer and the second well layer may have the same composition and have different composition ratios.

A number of the first holes and a number of the second holes may be different from each other.

In accordance with one or more embodiments of the present disclosure, there is provided a method of manufacturing a light emitting element, the method including: sequentially forming a first semiconductor layer, an active layer, and a second semiconductor layer in a first direction on a substrate, wherein the forming of the active layer on the first semiconductor layer includes: forming a first barrier layer on the first semiconductor layer; forming a well layer on the first barrier layer; partially etching the well layer; and forming a second barrier layer on the well layer.

In the partially etching of the well layer, a plurality of holes may be formed by etching, in the first direction, at least one area of the well layer along a second direction intersecting the first direction.

In the forming of the well layer, at least one of GaN, GaInP, AIGalnP, InGaN, or InGaAsP may be grown using Metal Organic Chemical Vapor Deposition (MOCVD). In the partially etching of the well layer, the at least one area of the well layer may be etched such that a composition ratio of indium (In) decreases.

The well layer may include a first area adjacent to a center of the well layer and a second area adjacent to an edge of the well layer. The plurality of holes may be provided in the second area.

The etching of the at least one area of the well layer in the first direction may include exposing the at least one area of the well layer to an etching gas.

The well layer may be formed at a first temperature, and the first barrier layer and the second barrier layer may be formed at a second temperature higher than the first temperature. In the exposing of the at least one area of the well layer to the etching gas, the etching gas may be exposed to the at least one area of the well layer while the temperature of the well layer is increased from the first temperature to the second temperature.

The etching gas may include a hydrogen (H₂) gas.

A size and a number of the plurality of holes may be controlled by at least one of an amount of the etching gas, an exposure time of the etching gas, or a size of the at least one area of the well layer exposed to the etching gas.

In accordance with one or more embodiments of the present disclosure, there is provided a display device including: a first electrode and a second electrode, provided on a substrate; a light emitting element provided between the first electrode and the second electrode; a first contact electrode electrically connecting the first electrode and the light emitting element to each other; and a second contact electrode electrically connecting the second electrode and the light emitting element to each other, wherein the light emitting element includes: a first semiconductor layer; an active layer provided on the first semiconductor layer; a second semiconductor layer provided on the active layer, the first semiconductor layer, the active layer, and the second semiconductor layer being sequentially provided in a first direction; and an insulative film around at least a portion of the first semiconductor layer, the active layer, and the second semiconductor layer, wherein the active layer includes a first barrier layer, a first well layer, and a second barrier layer, which are sequentially provided in the first direction, and wherein the first well layer includes first holes penetrating the first well layer.

According to an aspect, there is provided a light emitting element as set out in claim 1. Additional features are set out in claims 2 to 10. According to an aspect, there is provided a method as set out in claim 11. Additional features are set out in claims 12 to 15.

### BRIEF DESCRIPTION OF THE DRAWINGS

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.
FIG. 1 is a perspective view schematically illustrating a light emitting element in accordance with embodiments of the present disclosure.
FIG. 2 is a sectional view illustrating one or more embodiments of the light emitting element shown in FIG. 1.
FIGS. 3A and 3B are each a sectional view illustrating an example of an active layer of the light emitting element shown in FIG. 1.
FIG. 4A is a perspective view illustrating one or more embodiments of a well layer constituting the active layer shown in FIG. 1.
FIG. 4B is a perspective view illustrating one or more embodiments of the well layer constituting the active layer shown in FIG. 1.
FIG. 5 is a sectional view illustrating one or more embodiments of the active layer shown in FIG. 3A.
FIG. 6 is a sectional view illustrating one or more embodiments of a well layer constituting the active layer shown in FIG. 3B.
FIG. 7 is a graph illustrating external quantum efficiency with respect to a current density of the active layer of the light emitting element shown in FIG. 1.
FIG. 8 is a graph illustrating a luminance change rate of light emitted from the active layer in the light emitting element shown in FIG. 1.
FIGS. 9-17 are each a schematic sectional view illustrating one or more acts of a manufacturing method of the light emitting element shown in FIG. 1.
FIG. 18 is a plan view illustrating a display device including a light emitting element in accordance with one or more embodiments of the present disclosure.
FIG. 19 is a sectional view illustrating one or more embodiments of a pixel included in the display device shown in FIG. 18.
FIG. 20 is a sectional view illustrating first to third pixels included in the display device shown in FIG. 18.

### DETAILED DESCRIPTION

Hereinafter, embodiments of the present disclosure will be described in more detail with reference to the accompanying drawings. Throughout the drawings, the same reference numerals are given to the same elements, and their overlapping descriptions will not be provided.

It will be understood that, although the terms first, second, etc. may be used herein to describe various elements, these elements should not be limited by these terms. These terms are only used to distinguish one element from another element. Thus, a first element could be termed a second element without departing from the teachings of the present invention. Similarly, a second element could be termed a first element.

As used herein, the singular forms "a," "an," and "the" are intended to include the plural forms as well, unless the context clearly indicates otherwise.

It will be further understood that the terms "includes," "including," "comprises," and/or "comprising," when used in this specification, specify the presence of stated features, steps, operations, elements, and/or components, but do not preclude the presence or addition of one or more other features, steps, operations, elements, components, and/or groups thereof.

As used herein, the terms "use," "using," and "used" may be considered synonymous with the terms "utilize," "utilizing," and "utilized," respectively.

As used herein, expressions such as "at least one of", "one of", and "selected from", when preceding a list of elements, modify the entire list of elements and do not modify the individual elements of the list. For example, "at least one selected from among a, b and c", "at least one of a, b or c", and "at least one of a, b and/or c" may indicate only a, only b, only c, both (e.g., simultaneously) a and b, both (e.g., simultaneously) a and c, both (e.g., simultaneously) b and c, all of a, b, and c, or variations thereof.

As used herein, the term "and/or" includes any and all combinations of one or more of the associated listed items.

Further, the use of "may" when describing embodiments of the present disclosure refers to "one or more embodiments of the present disclosure".

It will be understood that when an element is referred to as being "on," "connected to," or "coupled to" another element, it may be directly on, connected, or coupled to the other element or one or more intervening elements may also be present. When an element is referred to as being "directly on," "directly connected to," or "directly coupled to" another element, there are no intervening elements present.

Spatially relative terms , such as "beneath," "below ," "lower," "above," "upper," "bottom," "top" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

As used herein, the terms "substantially", "about", and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any subrange subsumed within the ranges expressly recited herein.

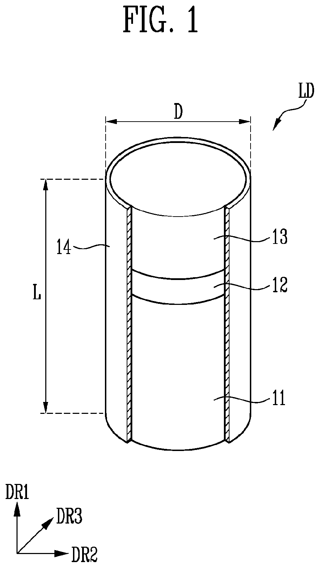

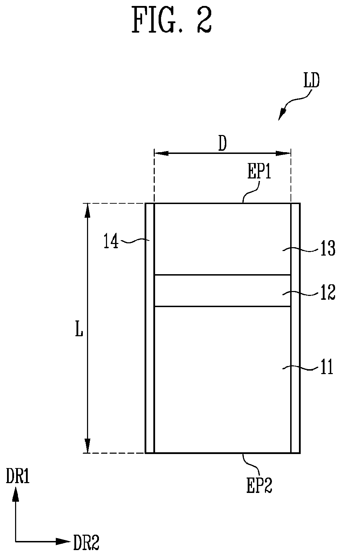

FIG. 1 is a perspective view schematically illustrating a light emitting element in accordance with embodiments of the present disclosure. FIG. 2 is a sectional view illustrating one or more embodiments of the light emitting element shown in FIG. 1.

Referring to FIGS. 1 and 2, the light emitting element LD may include a first semiconductor layer 11, a second semiconductor layer 13, and an active layer 12 interposed between the first and second semiconductor layers 11 and 13. In one or more embodiments, the light emitting element LD may be implemented with a light emitting stack structure (or stack pattern) in which the first semiconductor layer 11, the active layer 12, and the second semiconductor layer 13 are sequentially stacked.

In one or more embodiments, the light emitting element LD may be provided in any suitable shape extending in one direction. When an extending direction of the light emitting element LD is a length direction, the light emitting element LD may include a first end portion EP1 and a second end portion EP2 along the length direction. One semiconductor layer selected from the first semiconductor layer 11 and the second semiconductor layer 13 may be located at the first end portion EP1 of the light emitting element LD, and the other semiconductor layer selected from the first semiconductor layer 11 and the second semiconductor layer 13 may be located at the second end portion EP2 of the light emitting element LD.

In one or more embodiments, the light emitting element LD may be provided in various suitable shapes. In one or more embodiments, the light emitting element LD may have a rod-like shape, a bar-like shape, a pillar-like shape, and/or the like, which is long in its length direction (e.g., its aspect ratio is greater than 1) as shown in FIG. 1. In some embodiments, the light emitting element LD may have a rod-like shape, a bar-like shape, a pillar-like shape, and/or the like, which is short in its length direction (e.g., its aspect ratio is smaller than 1). In some embodiments, the light emitting element LD may have a rod-like shape, a bar-like shape, a cube-like shape, a pillar-like shape, and/or the like, of which aspect ratio is 1.

The light emitting element LD may include, for example, a light emitting diode (LED) manufactured small enough to have a diameter D and/or a length L to a degree of a nano scale (in nanometers) to a micro scale (in micrometers).

In one or more embodiments, when the light emitting element LD is long in its length direction (i.e., its aspect ratio is greater than 1), the diameter D of the light emitting element LD may be about 0.5 *µ*m to about 6 *µ*m, and the length L of the light emitting element LD may be about 1 *µ*m to about 10 *µ*m. However, the diameter D and the length L of the light emitting element LD are not limited thereto, and the size of the light emitting element LD may be changed in accordance with required (or desired) conditions (e.g., design conditions) of a lighting device and/or a self-luminous display device, to which the light emitting element LD is applied.

In one or more embodiments, the first semiconductor layer 11 may include, for example, at least one n-type semiconductor layer. The first semiconductor layer 11 may include an upper surface in contact with the active layer 12 and a lower surface exposed to the outside along the width direction of the light emitting element LD. The lower surface of the first semiconductor layer 11 may be one end portion (e.g., bottom end portion) of the light emitting element LD.

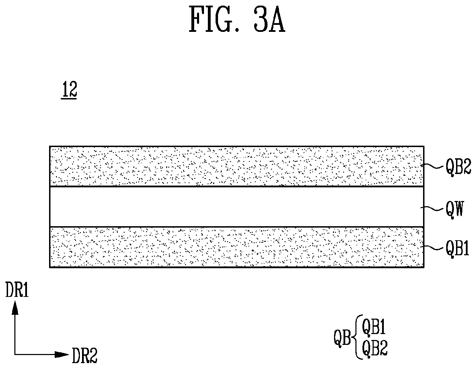

In one or more embodiments, the active layer 12 is formed on the first semiconductor layer 11, and may be formed in a single or multiple quantum well structure. In one or more embodiments, when the active layer 12 is formed in the multiple quantum well structure, a barrier layer (e.g., a barrier layer QB shown in FIG. 3A) and a well layer (e.g., a well layer QW shown in FIG. 3A), which constitute one unit, may be periodically and repeatedly stacked in the active layer 12. In one or more embodiments, the barrier layer may further include a strain reinforcing layer. The strain reinforcing layer may have a relatively small lattice constant, to further reinforce strain, e.g., compressive strain applied to the well layer. However, the structure of the active layer 12 is not limited to the above-described embodiment.

In one or more embodiments, the active layer 12 may emit light having a wavelength of about 400 nm to about 900 nm, and may use a double hetero structure. The double hetero structure may represent barrier layers structure with a high band gap. The active layer 12 may include a first surface in contact with the first semiconductor layer 11 and a second surface in contact with the second semiconductor layer 13.

In one or more embodiments, a color (e.g., light output color) of the light emitting element LD may be determined according to a wavelength of light emitted from the active layer 12. The color of the light emitting element LD may determine a color of a pixel corresponding thereto. For example, the light emitting element LD may emit red light, green light, and/or blue light.

In one or more embodiments, when an electric field having a set or predetermined voltage or more (e.g., a voltage higher than the set or predetermined voltage) is applied to both end portions of the light emitting element LD, the light emitting element LD may emit light as electron-hole pairs are combined in the active layer 12. The light emission of the light emitting element LD is controlled (e.g., facilitated) by using such a principle, so that the light emitting element LD can be used as a light source (e.g., light emitting source) for various suitable light emitting devices, including a pixel of a display device.

In one or more embodiments, the second semiconductor layer 13 is formed on the second surface of the active layer 12, and may include a semiconductor layer having a type (e.g., a p-type or n-type) different from that of the first semiconductor layer 11.

In one or more embodiments, the second semiconductor layer 13 may include a lower surface in contact with the second surface of the active layer 12 and an upper surface exposed to the outside along the width direction of the light emitting element LD. The upper surface of the second semiconductor layer 13 may be the other end portion (e.g., top end portion) of the light emitting element LD.

In one or more embodiments, the first semiconductor layer 11 and the second semiconductor layer 13 may have different thicknesses in the length direction of the light emitting element LD. In one or more embodiments, the first semiconductor layer 11 may have a thickness relatively thicker than that of the second semiconductor layer 13 along the length direction of the light emitting element LD. Accordingly, the active layer 12 of the light emitting element LD may be located more adjacent (e.g., closer) to the upper surface of the second semiconductor layer 13 than to the lower surface of the first semiconductor layer 11.

Although it is illustrated that each of the first semiconductor layer 11 and the second semiconductor layer 13 is configured with one layer, embodiments of the present disclosure are not limited thereto. In one or more embodiments, each of the first semiconductor layer 11 and the second semiconductor layer 13 may further include at least one layer, e.g., a clad layer and/or a Tensile Strain Barrier Reducing (TSBR) layer according to the material of the active layer 12. The TSBR layer may be a strain reducing layer provided between semiconductor layers having different lattice structures to perform a buffering function for reducing a lattice constant difference. The TSBR layer may be configured with a p-type semiconductor layer such as p-GAInP, p-AllnP, and/or p-AIGalnP, but embodiments of the present disclosure are not limited thereto.

In one or more embodiments, the light emitting element LD may further include a contact electrode (hereinafter, referred to as a "first contact electrode") provided on the top of the second semiconductor layer 13, in addition to the first semiconductor layer 11, the active layer 12, and the second semiconductor layer 13, which are described above. In some embodiments, the light emitting element LD may further include another contact electrode (hereinafter, referred to as a "second contact electrode") provided at one end of the first semiconductor layer 11.

In one or more embodiments, each of the first and second contact electrodes may be an ohmic contact electrode, but embodiments of the present disclosure are not limited thereto. In some embodiments, each of the first and second contact electrodes may be a Schottky contact electrode. The first and second contact electrodes may include a conductive material.

In one or more embodiments, the light emitting element LD may further include an insulative film 14 (or insulating film). However, in some embodiments, the insulative film 14 may not be provided (e.g., may be omitted), or may be provided to cover only portions of the first semiconductor layer 11, the active layer 12, and the second semiconductor layer 13.

In one or more embodiments, the insulative film 14 can prevent or reduce the risk of an electrical short circuit which may occur when the active layer 12 is in contact with a conductive material in addition to the first semiconductor layer 11 and the second semiconductor layer 13. The insulative film 14 also minimizes or reduces a surface defect of the light emitting element LD, thereby improving the lifetime and light emission efficiency of the light emitting element LD. Also, when a plurality of light emitting elements LD are densely provided, the insulative film 14 can prevent or reduce the occurrence of an unwanted short circuit between the light emitting elements LD. Whether the insulative film is provided is not limited (e.g., the insulative film may not be provided) as long as the active layer 12 can suitably prevent or reduce the occurrence of a short circuit with external conductive material.

In one or more embodiments, the insulative film 14 may be provided in a shape entirely surrounding (e.g., around) an outer periphery (e.g., an outer circumference) of the light emitting stack structure including the first semiconductor layer 11, the active layer 12, and the second semiconductor layer 13.

Although a case where the insulative film 14 is provided in a shape entirely surrounding (e.g., around) an outer circumference of each of the first semiconductor layer 11, the active layer 12, and the second semiconductor layer 13 is described in the above-described embodiment, embodiments of the present disclosure are not limited thereto.

In one or more embodiments, the insulative film 14 may include a transparent insulating material. For example, the insulative film 14 may include at least one insulating material selected from the group consisting of silicon oxide (SiOₓ), silicon nitride (SiNₓ), silicon oxynitride (SiOₓN_{y}), aluminum oxide (AlOₓ), titanium dioxide (TiC₂), hafnium oxide (HfOₓ), titanium strontium oxide (SrTiOₓ), cobalt oxide (CoₓO_{y}), magnesium oxide (MgO), zinc oxide (ZnO), ruthenium oxide (RuOₓ), nickel oxide (NiO), tungsten oxide (WOₓ), tantalum oxide (TaOₓ), gadolinium oxide (GdOₓ), zirconium oxide (ZrOₓ), gallium oxide (GaOₓ), vanadium oxide (VₓO_{y}), ZnO:AI, ZnO:B, InxOy:H, niobium oxide (NbₓO_{y}), magnesium fluoride (MgFₓ), aluminum fluoride (AlFₓ), Alucone polymer film, titanium nitride (TiN), tantalum nitride (TaN), aluminum nitride (AlNₓ), gallium nitride (GaN), tungsten nitride (WN), hafnium nitride (HfN), niobium nitride (NbN), gadolinium nitride (GdN), zirconium nitride (ZrN), vanadium nitride (VN), and combinations thereof. However, embodiments of the present disclosure are not limited thereto, and one or more suitable materials having insulating properties may be used as the material of the insulative film 14.

In one or more embodiments, the insulative film 14 may be provided in the form of a single layer or be provided in the form of a multi-layer including at least two layers.

The above-described light emitting element LD may be used as a light emitting source (e.g., light source) for various suitable display devices. The light emitting element LD may be manufactured through a surface treatment process. For example, when a plurality of light emitting elements LD are mixed in a liquid solution (e.g., solvent) to be supplied to each pixel area (e.g., an emission area of each pixel and/or an emission area of each sub-pixel), each light emitting element LD may be surface-treated such that the light emitting elements LD are not unequally condensed (e.g., non-uniformly distributed) in the solution but are substantially equally dispersed (e.g., substantially uniformly distributed) in the solution.

A light emitting unit (or light emitting device) including the light emitting element LD according to the present embodiments may be used in various types (or kinds) of devices that require a light source, including a display device. When a plurality of light emitting elements LD are provided in an emission area of each pixel of a display panel, the light emitting elements LD may be used as a light source of the pixel. However, the application field of the light emitting element LD is not limited to the above-described example. For example, the light emitting element LD may be used for other types (or kinds) of electronic devices that require a light source, such as a lighting device.

However, a light emitting element applied to display devices in accordance with embodiments of the present disclosure is not limited thereto. For example, the light emitting element may be a flip chip type (or kind) micro light emitting diode and/or an organic light emitting element including an organic emitting layer.

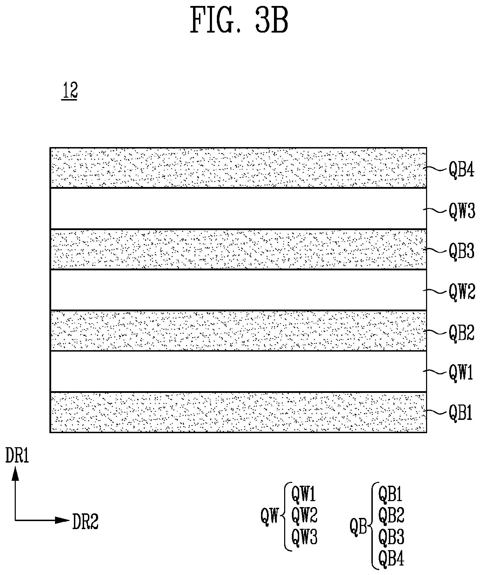

FIGS. 3A and 3B are each a sectional view illustrating one or more embodiments of the active layer of the light emitting element shown in FIG. 1.

Referring to FIGS. 3A and 3B, the active layer 12 may include a barrier layer QB and a well layer QW. FIG. 3A illustrates a single quantum well structure including one well layer, and FIG. 3B illustrates a multiple quantum well structure including a plurality of quantum layers.

Referring to FIGS. 1 and 3A, the active layer 12 may include first and second barrier layers QB1 and QB2 and a well layer QW. The first barrier layer QB1 may be provided between the first semiconductor layer 11 and the well layer QW. The second barrier layer QB2 may be provided between the well layer QW and the second semiconductor layer 13.

Referring to FIGS. 1 and 3B, the barrier layer QB may include first, second, third, and fourth barrier layers QB1, QB2, QB3, and QB4. The well layer QW may include first, second, and third well layers QW1, QW2, and QW3. In one or more embodiments, the active layer 12 may have a multi-layer structure in which the first, second, third, and fourth barrier layers QB1, QB2, QB3, and QB4 are stacked alternately with the first, second, and third well layers QW1, QW2, and QW3, respectively. In one or more embodiments, the first barrier layer QB1 and the second barrier layer QB2 may be formed on the first semiconductor layer 11 with the first well layer QW1 interposed therebetween. The second barrier layer QB2 and the third barrier layer QB3 may be formed on the first well layer QW1 with the second well layer QW2 interposed therebetween. The third barrier layer QB3 and the fourth barrier layer QB4 may be formed on the second well layer QW2 with the third well layer QW3 interposed therebetween.

Although a case where the active layer 12 has a multiple quantum well structure and three pairs of well structures (e.g., the first, second, third, and fourth barrier layers QB1, QB2, QB3, and QB4 and the first, second, and third well layers QW1, QW2, and QW3) are stacked is illustrated in FIG. 3B, embodiments of the present disclosure are not limited thereto. For example, the active layer 12 may have two pairs or four pairs or more (e.g., four pairs to nine pairs) of well structures.

In one or more embodiments, the first to fourth barrier layers QB1 to QB4 may have the same thickness in a first direction DR1. However, embodiments of the present disclosure are not limited thereto, and at least some of the first to fourth barrier layers QB1 to QB4 may have different thicknesses in the first direction DR1. The first to fourth barrier layers QB1 to QB4 may have different thicknesses according to a process condition for each of the first to fourth barrier layers QB1 to QB4 in a manufacturing process of the barrier layer QB.

Hereinafter, when first, second, and third well layers QW1, QW2, and QW3 are inclusively designated (e.g., when a reference is being made to all of the first, second, and third well layers QW1, QW2, and QW3) , the first, second, and third well layers QW1, QW2, and QW3 (each and collectively) will be referred to as a well layer QW. When first, second, third, and fourth barrier layers QB1, QB2, QB3, and QB4 are inclusively designated (e.g., when a reference is being made to all of the first, second, third, and fourth barrier layers QB1, QB2, QB3, and QB4), the first, second, third, and fourth barrier layers QB1, QB2, QB3, and QB4 (each and collectively) will be referred to as a barrier layer QB.

In one or more embodiments, a thickness of the barrier layer QB in the first direction DR1 may be different from a thickness of the well layer QW in the first direction DR1. For example, the thickness of the barrier layer QB may be thicker (e.g., larger) than the thickness of the well layer QW.

In one or more embodiments, the barrier layer QB and the well layer QW may have different compositions. For example, the well layer QW may include at least one selected from among GaN, GaInP, AIGalnP, InGaN, and InGaAsP. The barrier layer QB may include at least one selected from among GaN, InGaN, AlGaP, and AlGaAs. For example, the well layer QW may have an indium (In) composition ratio higher than an indium (In) composition ratio of the barrier layer QB.

In one or more embodiments, the first, second, and third well layers QW1, QW2, and QW3 may have the same composition. However, embodiments of the present disclosure are not limited thereto, and the first, second, and third well layers QW1, QW2, and QW3 may have different compositions. For example, when the first and second well layers QW1 and QW2 include InGaN, the third well layer QW3 may include GaN.

In one or more embodiments, when the first, second, and third well layers QW1, QW2, and QW3 have the same composition, the first, second, and third well layers QW1, QW2, and QW3 may have different composition ratios. However, embodiments of the present disclosure are not limited thereto, and the first, second, and third well layers QW1, QW2, and QW3 may have the same composition ratio.

In one or more embodiments, the first to fourth barrier layers QB1, QB2, QB3, and QB4 may have the same composition. However, embodiments of the present disclosure are not limited thereto, and the first to fourth barrier layers QB1, QB2, QB3, and QB4 may have different compositions.

In one or more embodiments, when the first to fourth barrier layers QB1, QB2, QB3, and QB4 may have the same composition, the first to fourth barrier layers QB1, QB2, QB3, and QB4 may have the same composition ratio. However, embodiments of the present disclosure are not limited thereto, and the first to fourth barrier layers QB1, QB2, QB3, and QB4 may have different composition ratios.

Referring to FIGS. 1, 3A, and 3B, electrons injected into the first semiconductor layer 11 and holes injected into the second semiconductor layer 13 are recombined in the well layer QW of the active layer 12, and accordingly, light corresponding to band gap energy of the well layer QW may be released.

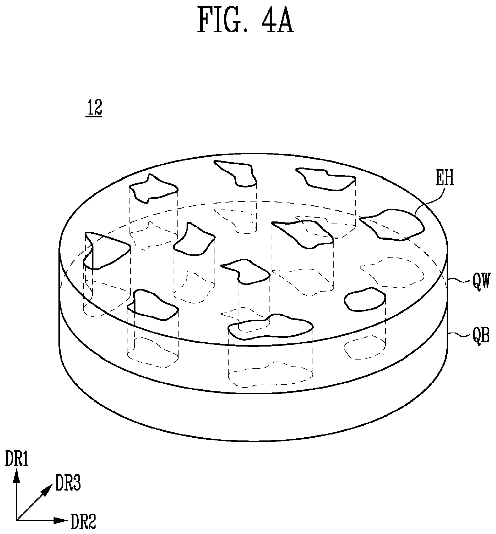

FIG. 4A is a perspective view illustrating one or more embodiments of the well layer constituting the active layer shown in FIG. 1.

The active layer 12 shown in FIG. 4A may have a single quantum well structure (see FIG. 3A), but embodiments of the present disclosure are not limited thereto. For example, when the active layer 12 has a multiple quantum well structure, a well layer QW shown in FIG. 4A represent at least one well layer among a plurality of well layers.

In one or more embodiments, the well layer QW may be provided on a barrier layer QB. The well layer QW may include a first surface and a second surface facing the first surface. In one or more embodiments, the first surface and the second surface of the well layer QW may in contact with the barrier layer QB. For example, when the first surface of the well layer QW is in contact with a first barrier layer (e.g., the first barrier layer QB1 shown in FIG. 3A), the second surface of the well layer QW may be in contact with a second barrier layer (e.g., the second barrier layer QB2 shown in FIG. 3A).

In one or more embodiments, the well layer QW may include a plurality of etching holes EH. The plurality of etching holes EH may penetrate the well layer QW in the first direction DR1. The etching holes EH may extend from the first surface to the second surface of the well layer QW.

In one or more embodiments, the etching holes EH may be provided while being spaced apart from each other. The etching holes EH may have different shapes. In one or more embodiments, the etching holes EH may have different sectional areas in the second direction DR2 (e.g., sectional area may refer to area of a cross-section taken along the second direction DR2).

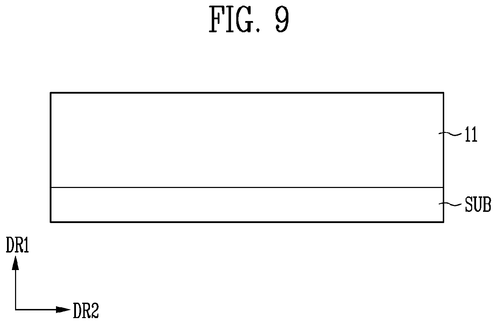

In one or more embodiments, the etching holes EH may be formed by partially removing the well layer QW. In one or more embodiments, when the well layer QW provided on the barrier layer QB is exposed to an etching gas, the plurality of etching holes EH may be formed. Hereinafter, a manufacturing method of the well layer QW including the plurality of etching holes EH will be described in more detail herein below with reference to FIGS. 9 to 17.

In one or more embodiments, the plurality of etching holes EH formed in the well layer QW may block or reduce a current path formed toward an edge of the well layer QW. For example, the plurality of etching holes EH may block (e.g., suppress or reduce) the movement of electrons injected into the well layer QW to the edge of the well layer QW.

In the light emitting element in accordance with the embodiments of the present disclosure, generation of a leakage current by electrons moved along the edge of the well layer QW through the plurality of etching holes EH formed in the well layer QW can be prevented (e.g., suppressed or reduced).

In the light emitting element in accordance with the embodiments of the present disclosure, change in characteristics (e.g., external quantum efficiency and/or a luminance change rate) of light emitted from the light emitting layer 12 by the leakage current can be reduced, thereby reducing the deterioration in the reliability of the light emitting element.

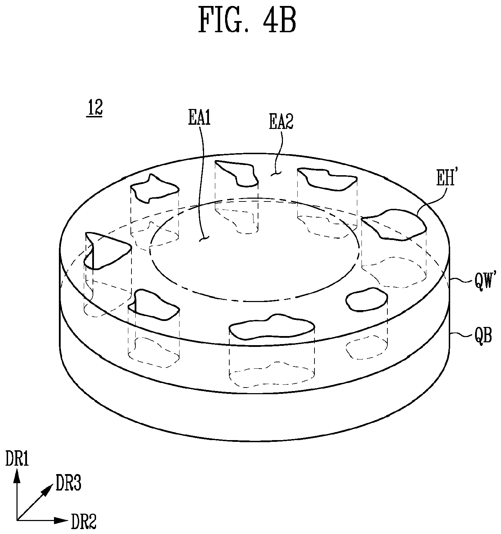

FIG. 4B is a perspective view illustrating one or more embodiments of the well layer constituting the active layer shown in FIG. 1.

Referring to FIGS. 4A and 4B, components except for a plurality of etching holes EH' are the same as those shown in FIG. 4A, and therefore, overlapping descriptions will not be provided (e.g., will be omitted).

Referring to FIG. 4B, a well layer QW' may include a first area EA1 and a second area EA2. In one or more embodiments, the first area EA1 may be an area adjacent to the center of the well layer QW'. The second area EA2 may be a peripheral area adjacent to an edge of the well layer QW'. The first area EA1 may be inside the second area EA2. The center of the well layer QW may be the center of gravity of the well layer QW' on a plane. The edge of the well layer QW may be one area of the well layer QW', which is spaced apart from the center of the well layer QW' at a set or predetermined distance.

In one or more embodiments, it is illustrated that the planar shape of the well layer QW' is a circular shape. However, embodiments of the present disclosure are not limited thereto, and the planar shape of the well layer QW may include a polygonal shape, for example.

The well layer QW' may include etching holes EH'. The etching holes EH' may be provided only in the second area EA2 of the well layer QW. For example, the etching holes EH' may be provided only in an area adjacent to the edge of the well layer QW'.

In one or more embodiments, the etching holes EH' may be provided in the second area EA2, so that the movement electrons injected in the first area EA1 to the edge of the well layer QW can be blocked (e.g., suppressed or reduced) .

In one or more embodiments, the etching holes EH' may be provided in an area adjacent to the edge of the well layer QW within a suitable range in which internal quantum efficiency (IQE) of the well layer QW is not deteriorated (or substantially not deteriorated).

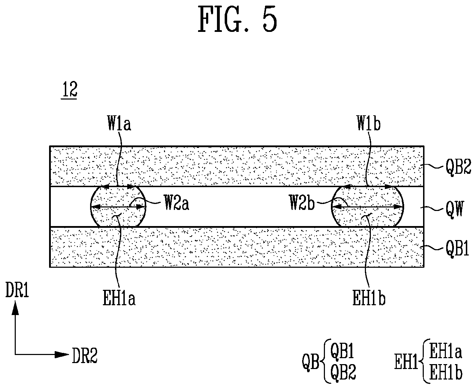

FIG. 5 is a sectional view illustrating one or more embodiments of the active layer shown in FIG. 3A.

Referring to FIG. 5, the well layer QW may be provided between the first barrier layer QB1 and the second barrier layer QB2. The well layer QW may include a plurality of etching holes EH1.

In one or more embodiments, the plurality of etching holes EH1 may include a first etching hole EH1a and a second etching hole EH1b. However, embodiments of the present disclosure are not limited thereto, and the plurality of etching holes EH1 may include third to Nth etching holes.

In one or more embodiments, the plurality of etching holes EH1 may penetrate the well layer QW in the first direction DR1. The plurality of etching holes EH1 may be provided along the second direction DR2. In one or more embodiments, the second direction DR2 may be a direction intersecting the first direction DR1. The first etching hole EH1a and the second etching hole EH1b may be provided while being spaced apart from each other.

In one or more embodiments, the plurality of etching holes EH1 may be formed in one or more suitable pillar shapes. In one or more embodiments, each of the plurality of etching holes EH1 may have a width varying in the first direction DR1. For example, a first with W1a of the first etching hole EH1a may be narrower than a second width W2a of the first etching hole EH1a. The first width W1a may be a width of the first etching hole EH1a in an area of the well layer QW in contact with the second barrier layer QB2. The second width W2a may be a width of the first etching hole EH1a at a middle point of the well layer QW relative to a length (e.g., thickness) direction of the well layer QW (e.g., the first direction DR1).

In one or more embodiments, the plurality of etching holes EH1 may have different widths. In one or more embodiments, the first width W1a of the first etching hole EH1a may be narrower than a first width W1b of the second etching hole EH1b. The first width W1a of the first etching hole EH1a and the first width W1b of the second etching hole EH1b may be widths of the plurality of etching holes EH1 in the area of the well layer QW in contact with the second barrier layer QB2. In one or more embodiments, the second width W2a of the first etching hole EH1a may be narrower than a second width W2b of the second etching hole EH1b.

In one or more embodiments, each of the plurality of etching holes EH1 may have widths symmetrical to each other (e.g., each of the plurality of etching holes EH1 may have a shape that is symmetrical) with respect to an axis in the second direction DR2. In one or more embodiments, the first width W1a of the first etching hole EH1a may be equal to a width of the first etching hole EH1a in an area of the well layer QW in contact with the first barrier layer QB1, but embodiments of the present disclosure are not limited thereto. For example, the first with W1a of the first etching hole EH1a may be longer than the width of the first etching hole EH1a in the area in contact with the first barrier layer QB1.

In one or more embodiments, the second barrier layer QB2 may fill spaces (e.g., grooves) formed by the plurality of etching holes EH1 formed in the well layer QW and the first barrier layer QB1. Because the well layer QW is formed on the first barrier layer QB1, the first barrier layer QB1 and the plurality of etching holes EH formed in the well layer QW may form grooves. For example, because the second barrier layer QB2 is formed on the well layer QW, the second barrier layer QB2 may fill at least one space of the grooves formed by the first barrier layer QB1 and the plurality of etching holes EH formed in the well layer QW.

In one or more embodiments, because indium condensed in the well layer QW has a relatively low energy as compared with other compositions, the indium may be first removed through an etching process on the well layer QW. For example, as the etch rate of the well layer QW becomes larger, the indium composition ratio of the well layer QW may become lower. As the etch rate of the well layer QW becomes larger, the size of each of the etching holes EH may become larger.

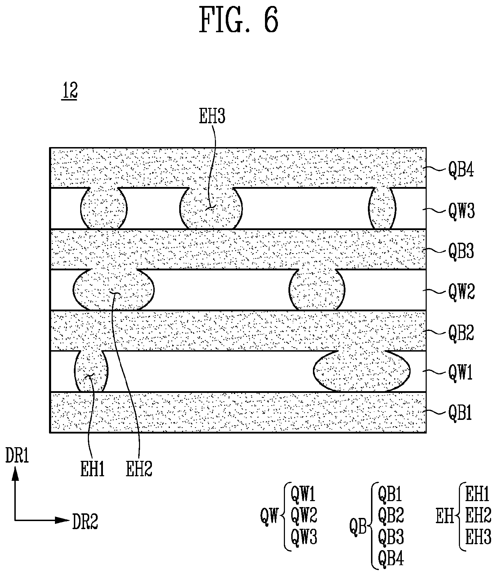

FIG. 6 is a sectional view illustrating one or more embodiments of the well layer constituting the active layer shown in FIG. 3B.

Referring to FIG. 6, the first well layer QW1 may include first etching holes EH1. The first etching holes EH1 may penetrate the first well layer QW1 in the first direction DR1. In one or more embodiments, the first etching holes EH1 may penetrate the first well layer QW1 to face the second barrier layer QB2 from the first barrier layer QB1.

In one or more embodiments, the second well layer QW2 may be provided between the second barrier layer QB2 and the third barrier layer QB3. In one or more embodiments, the second well layer QW2 may include second etching holes EH2. The second etching holes EH2 may penetrate the second well layer QW2 in the first direction DR1. In one or more embodiments, the second etching holes EH2 may penetrate the second well layer QW2 to face the third barrier layer QB3 from the second barrier layer QB2.

In one or more embodiments, the third well layer QW3 may be provided between the third barrier layer QB3 and the fourth barrier layer QB4. In one or more embodiments, the third well layer QW3 may include third etching holes EH3. The third etching holes EH3 may penetrate the third well layer QW3 in the first direction DR1. In one or more embodiments, the third etching holes EH3 may penetrate the third well layer QW3 to face the fourth barrier layer QB4 from the third barrier layer QB3.

In one or more embodiments, the first, second, and third well layers QW1, QW2, and QW3 may include at least one material selected from among GalnP, AIGalnP, InGaN, and InGaAsP.

In one or more embodiments, etching holes EH may be formed by partially etching the well layer QW. In one or more embodiments, the first etching holes EH1 may be formed by partially etching the first well layer QW1. The second and third etching holes EH2 and EH3 may also be formed in substantially the same manner as the first etching holes EH1, by partially etching the second and third well layers QW2 and QW3, respectively.

In one or more embodiments, the first, second, and third well layers QW1, QW2, and QW3 may have the same composition (e.g., may include the same materials), and have different composition ratios (e.g., the materials may be included in different proportions). For example, when the composition of the first, second, and third well layers QW1, QW2, and QW3 is composed of indium (In), gallium (Ga), and nitrogen (N), an indium composition ratio of the third well layer QW3 may be smaller than an indium composition ratio of each of the first and second well layers QW1 and QW2. For example, when an etch rate of the third well layer QW3 is set greater than an etch rate of each of the first and second well layers QW1 and QW2, an amount of indium removed from the third well layer QW3 may be relatively large. In another example, the first, second, and third well layers QW1, QW2, and QW3 may have the same composition, and also have the same composition ratio. For example, when each of the first, second, and third well layers QW1, QW2, and QW3 is etched according to the same material and process condition, the first, second, and third well layers QW1, QW2, and QW3 may have the same composition and the same composition ratio. In one or more embodiments, each of numbers and sizes of the etching holes EH may vary according to an etching process condition of the well layer QW, used to form the etching holes EH. In one or more embodiments, etching on the first, second, and third well layers QW1, QW2, and QW3 may be performed under different process conditions.

In one or more embodiments, numbers (e.g., parameters) of the first, second, and third etching holes EH1, EH2, and EH3 may be different from one another. In one or more embodiments, widths of the first etching holes EH1, the second etching holes EH2, and the third etching holes EH3 may be different from one another.

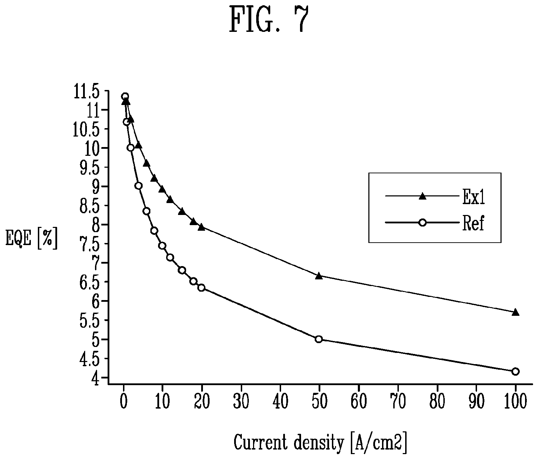

FIG. 7 is a graph illustrating external quantum efficiency with respect to a current density of the active layer of the light emitting element shown in FIG. 1.

Reference numeral Ref shown in FIG. 7 is a comparative example representing a case where one area of a well layer is not exposed to an etching gas, and reference numeral Ex1 is a first embodiment representing a case where one area of a well layer QW is exposed to the etching gas. In one or more embodiments, the etching gas may include a hydrogen (H₂) gas.

Referring to FIG. 7, in the entire section with respect to current density, external quantum efficiency (EQE) of the first embodiment Ex1 may be higher than EQE of the comparative example Ref. A plurality of etching holes EH may be formed in the well layer QW in accordance with the first embodiment Ex1. The well layer QW in accordance with the first embodiment Ex1 can block or reduce a current path toward an edge of the well layer QW through the plurality of etching holes EH. For example, the well layer QW in accordance with the first embodiment Ex1 can prevent or reduce a decrease in ratio of light emitted from the well layer QW due to a leakage current.

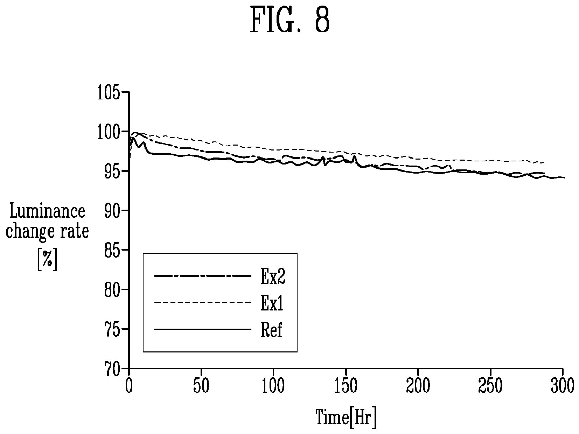

FIG. 8 is a graph illustrating a luminance change rate of light emitted from the active layer in the light emitting element shown in FIG. 1.

Reference numeral Ref shown in FIG. 8 is a comparative example representing a case where one area of a well layer is not exposed to an etching gas, reference numeral Ex1 is a first embodiment representing a case where one area of a well layer QW is exposed to the etching gas for a first time (e.g., for a first length of time), and reference numeral Ex2 is a second embodiment representing a case where one area of the well layer QW is exposed to the etching gas for a second time (e.g., for a second length of time). In one or more embodiments, the etching gas may include a hydrogen (H₂) gas. The first length of time may be longer than the second length of time. For example, the first length of time may be about 90 seconds and the second length of time may be about 60 seconds.

Referring to FIG. 8, the comparative example Ref has a larger luminance change rate according to a lapse of time, as compared with the first embodiment Ex1 and the second embodiment Ex2. In the comparative example Ref, a current path toward an edge of the well layer is formed in the well layer, and therefore, a leakage current may be generated by electrons moved to the current path. For example, the luminance change rate of light emitted from the well layer may be increased by the leakage current. Reliability of light emitted from the well layer in accordance with the comparative example Ref may be lower than reliability of light emitted from the well layer QW in accordance with the first embodiment Ex1 and the second embodiment Ex2.

The first embodiment Ex1 has a luminance change rate smaller than a luminance change rate of the second embodiment Ex2. The first embodiment Ex1 has a long time for which the one area of the well layer QW is exposed to the etching gas, as compared with the second embodiment Ex2. As time for which the one area of the well layer QW is exposed to the etching gas becomes longer, a relatively larger number of current paths toward the edge of the well layer QW may be blocked. Accordingly, in the first embodiment Ex1, an amount of current leaked through the current path can be reduced as compared with the second embodiment Ex2. A degree to which the luminance of light emitted from the well layer QW in accordance with the first embodiment Ex1 is decreased by the leakage current may be lower than a degree to which the luminance of light emitted from the well layer QW in accordance with the second embodiment Ex2 is decreased by the leakage current.

FIGS. 9 to 17 are each a schematic sectional view illustrating one or more acts of a manufacturing method of the light emitting element shown in FIG. 1.

Referring to FIG. 9, a first semiconductor layer 11 may be formed on the substrate SUB.

The substrate SUB may be a base plate for stacking a target material. The substrate SUB may be a wafer for epitaxial growth for a set or predetermined material. In one or more embodiments, the substrate SUB may be any one of a sapphire substrate, a GaAs substrate, a Ga substrate, or an InP substrate, but embodiments of the present disclosure are not limited thereto. For example, when a set or specific material satisfies a selectivity for manufacturing a light emitting element LD, and epitaxial growth for a set or predetermined material smoothly or suitably occurs, the set or specific material may be selected as the material of the substrate SUB. The shape of the substrate SUB may be a polygonal shape including a rectangular shape or a circular shape, but embodiments of the present disclosure are not limited thereto.

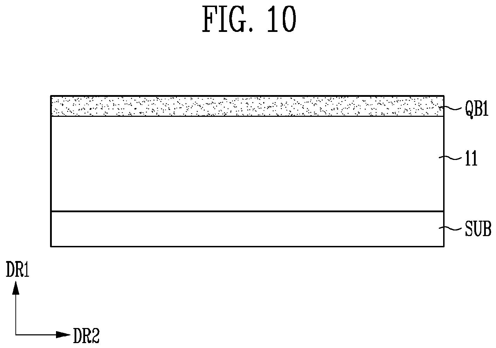

Although a case where the first semiconductor layer 11 is provided on the substrate SUB is illustrated in FIG. 10, an undoped semiconductor layer may be formed between the substrate SUB and the first semiconductor layer 11. The undoped semiconductor layer may be a semiconductor layer in which any dopant is not provided so as to suppress or reduce a defect in the first semiconductor layer 11. The undoped semiconductor layer may include any one semiconductor material selected from among InAlGaN, GaN, AlGaN, InGaN, AIN, and InN, and a separate dopant may not be provided in the undoped semiconductor layer. An etch rate of the undoped semiconductor layer in which a dopant is not provided may be different from an etch rate of the first semiconductor layer 11.

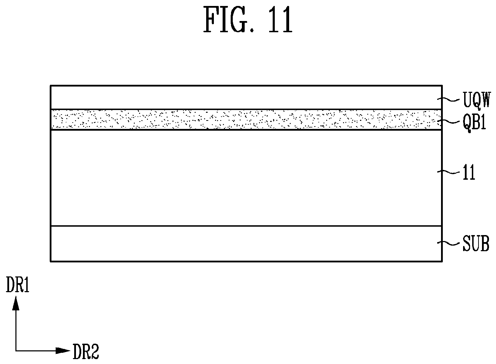

Referring to FIGS. 10 and 11, a first barrier layer QB1 and a well layer UQW of an active layer (e.g., the active layer 12 shown in FIG. 1) may be sequentially formed in the first direction DR1 on the first semiconductor layer 11.

In one or more embodiments, the well layer UQW may include at least one selected from among GalnP, AIGalnP, InGaN, and InGaAsP. The first barrier layer QB1 may include at least one selected from among GaN, InGaN, AIGnP, and AlGaAs.

In one or more embodiments, a lattice mismatch between the first semiconductor layer 11 and the well layer UQW may be increased such that the well layer UQW can include a relatively large content of indium (In). Thus, the first barrier layer QB1 is interposed between the first semiconductor layer 11 and the well layer UQW, thereby reducing the lattice mismatch between the first semiconductor 11 and the well layer UQW.

In one or more embodiments, the first barrier layer QB1 may be grown in a high temperature section including a first temperature, and the well layer UQW may be grown at a second temperature lower than the first temperature. The first barrier layer QB1 may be grown at a temperature higher than the temperature at which the well layer UQW is grown so as to ensure suitable crystallinity of the first barrier layer QB1.

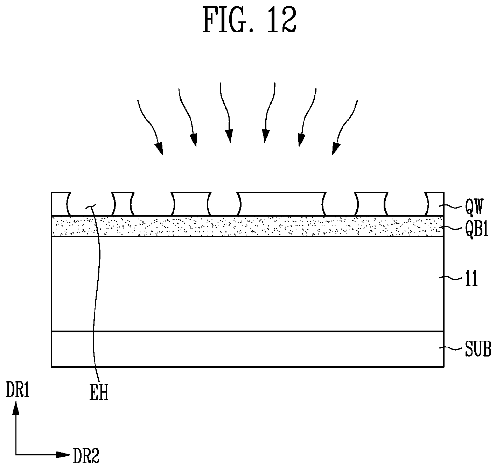

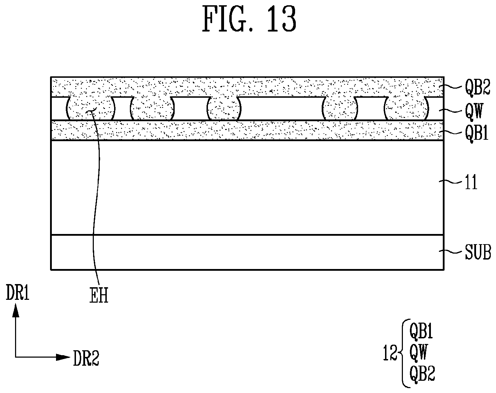

Referring to FIGS. 12 and 13, at least one area of the well layer UQW may be etched, thereby forming a well layer QW including a plurality of etching holes EH.

In one or more embodiments, one area of the well layer UQW may be etched in the first direction DR1, thereby forming a plurality of etching holes EH. At least one area of the well layer UQW may be exposed to an etching gas. The plurality of etching holes EH may correspond to an area in which the one area of the well layer UQW is etched and removed. The plurality of etching holes EH may penetrate the well layer QW in the first direction DR1.

In one or more embodiments, the etching gas may include a hydrogen (H₂) gas, but embodiments of the present disclosure are not limited thereto. For example, the etching gas may be a mixed gas including the hydrogen gas.

In one or more embodiments, indium (In) condensed in the well layer UQW may be removed by the etching gas. Because the condensed indium (In) has a relatively low bonding energy, the condensed indium (in) may be removed earlier (e.g., sooner) than other materials by the etching gas.

In one or more embodiments, the composition ratio of the well layer QW may vary according to a process condition of etching. In one or more embodiments, when the well layer QW includes InₓGa₁₋ₓN (0<x<1), a composition X (e.g., coefficient x) of the indium (In) of the well layer QW may be about 0.05 to about 0.4. An indium composition ratio of the well layer QW may be lower than an indium composition ratio of the well layer UQW before an etching process is performed.

In one or more embodiments, after the well layer UQW is formed at the first temperature, the temperature of the well layer UQW may be increased to the second temperature for the purpose of a subsequent process. A partial etching process of the well layer UQW may be performed while the temperature of the well layer UQW is increased from the first temperature to the second temperature. In one or more embodiments, a size and a number of the plurality of etching holes EH may be controlled by at least one selected from among an amount of the etching gas, a partial pressure of the etching gas, an exposure time of the etching gas, and a size of one area of the well layer UQW, which is exposed to the etching gas. In one or more embodiments, as the amount of the etching gas becomes larger, the size of the plurality of etching holes EH may become larger. As the partial pressure of the etching gas becomes higher, the size of the plurality of etching holes EH may become larger. As the exposure time of the etching gas becomes longer, the size of the plurality of etching holes EH may become larger. As the number of one areas of the well layer UQW, exposed to the etching gas, becomes larger, the number of the plurality of etching holes EH may become larger.

Referring to FIG. 13, a second barrier layer QB2 may be formed over the well layer QW.

In one or more embodiments, the second barrier layer QB2 may be formed at the second temperature. In one or more embodiments, the second barrier layer QB2 may be formed of the same material as the first barrier layer QB1.

In one or more embodiments, the second barrier layer QB2 may fill the plurality of etching holes EH formed in the well layer QW.

In the above, a manufacturing method when the active layer 12 has a single quantum well structure has been described. However, when the active layer 12 has a multiple quantum well structure, a process of forming a barrier layer QB and a well layer QW is repeated, so that the active layer including the multiple quantum well structure can be formed.

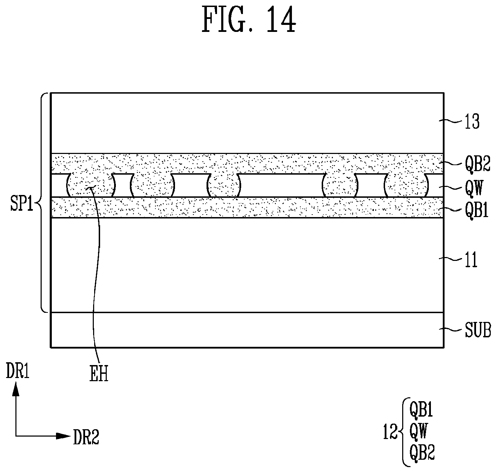

Referring to FIG. 14, a second semiconductor layer 13 may be formed on the second barrier layer QB2.

In one or more embodiments, the first semiconductor layer 11, the active layer 12, and the second semiconductor layer 13, which are sequentially stacked in the first direction DR1 on the substrate SUB, may be configured as a first stack structure SP1.

In one or more embodiments, an electrode layer may be formed on the second semiconductor layer 13. The electrode layer may minimize or reduce loss of light released to the outside. In one or more embodiments, the electrode layer may include a transparent metal oxide so as to improve a current spreading effect to the second semiconductor layer 13.

The first semiconductor layer 11, the active layer 12, and the second semiconductor layer 13 may be formed by epitaxial growth, and be formed using any one method selected from among Metal Organic Chemical Vapor-phase Deposition (MOCVD), Molecular Beam Epitaxy (MBE), Vapor Phase Epitaxy (VPE), and Liquid Phase Epitaxy (LPE).

As described above, the first semiconductor layer 11 and the second semiconductor layer 13 may be configured as semiconductor layers of different types (e.g., having different dopants). The active layer 12 is located between the first semiconductor layer 11 and the second semiconductor layer 13, which have different polarities, so that light can be released from the active layer 12 when electrical information having a threshold voltage or higher is provided to both ends of the light emitting element LD.

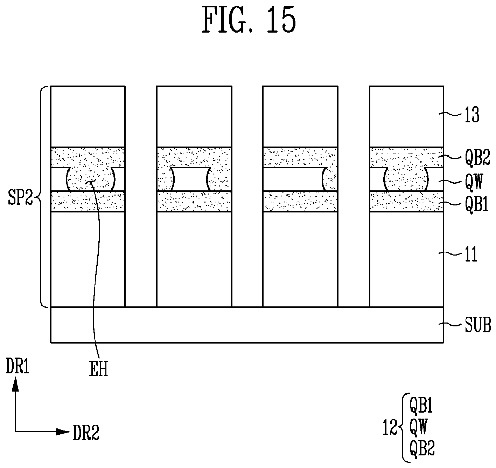

Referring to FIG. 15, the first stack structure SP1 may be etched in a stacking direction (e.g., the first direction DR1), thereby forming second stack structures SP2. Each of the second stack structures SP2 may correspond to a structure in which one area of the first stack structure SP1 is etched and removed along the stacking direction. Each of the second stack structures SP2 may be a structure in which the first semiconductor layer 11, the active layer 12, and the second semiconductor layer 13 are sequentially arranged.

In order to form the second stack structures SP2, a mask may be provided on a front surface of the first stack structure SP1, and patterning at a distance of nano scale to micro scale (e.g., to achieve a pattern depth on a nano scale to micro scale) may be performed through an etching process. In one or more embodiments, the etching process for forming the second stack structures SP2 may be a dry etching process. The dry etching process may be any one selected from among Reactive Ion Etching (RIE), Reactive Ion Bream Etching (RIBE), and Inductively Coupled Plasma Reactive Ion Etching (ICP-RIE).

The above-described etching process may be performed in a direction toward the first semiconductor layer 11 from the second semiconductor layer 13.

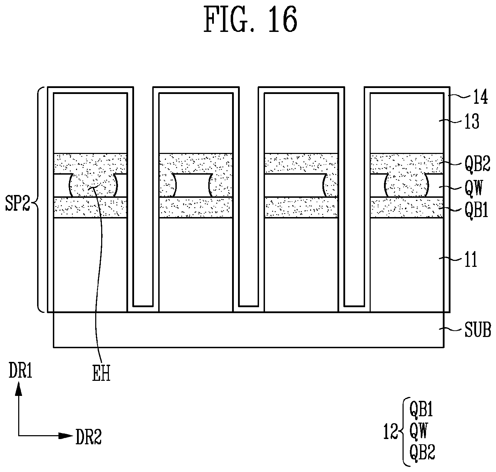

Referring to FIG. 16, an insulative film 14 for covering the first semiconductor layer 11, the active layer 12, and the second semiconductor layer 13 may be formed. For example, the insulative film 14 may cover the second stack structures SP2.

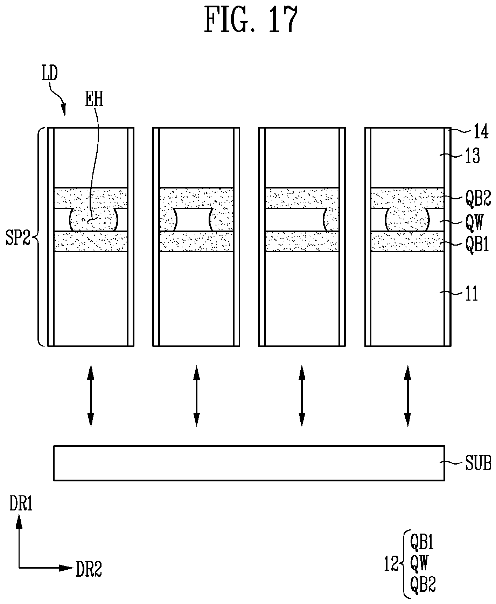

Referring to FIG. 17, the insulative film 14 over the second stack structures SP2 may be removed, and the second stack structures SP2 may be separated from the substrate SUB, thereby forming the light emitting element LD. Each of the stack structures SP2 separated from the substrate SUB may be provided as the light emitting element LD.

In one or more embodiments, the insulative film 14 may have the same height as the second stack structure SP2.

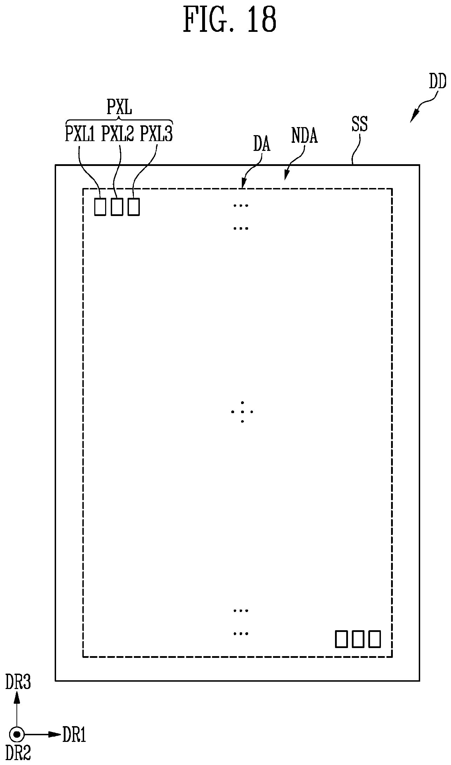

Hereinafter, a display device including a light emitting element LD in accordance with one or more embodiments of the present disclosure will be described with reference to FIGS. 18 to 20.

FIG. 18 is a plan view illustrating a display device including the light emitting element in accordance with one or more embodiments of the present disclosure.

In FIG. 18, an example of the display device DD capable of using a light emitting element LD as a light source is illustrated. In FIG. 16, a structure of the display device DD will be briefly illustrated based on a display area DA. However, in some embodiments, at least one driving circuit (e.g., at least one of a scan driver and/or a data driver), lines, and/or pads may be further provided in the display device DD.

Referring to FIG. 18, the display device DD may include a substrate SS and pixels PXL provided on the substrate SS. The pixel PXL may be provided in plurality on the substrate SS.

The substrate SS is used to constitute a base member of the display device DD, and may be a rigid or flexible substrate or film.

The display device DD and the substrate SS for forming the same may include the display area DA for displaying an image and a non-display area NDA except (e.g., other than) the display area DA.

The pixel PXL may be provided in the display area DA. The pixel PXL may include a light emitting element LD. The light emitting element LD may be the light emitting element described with reference to FIGS. 1 and 2, and 18. One or more suitable lines, pads, and/or a built-in circuit, which are connected to the pixels PXL of the display area DA, may be provided in the non-display are NDA. The pixels PX may be regularly arranged according to a strip arrangement structure, a PENTILE^{®} arrangement structure (PENTILEO is a registered trademark owned by Samsung Display Co., Ltd.), and/or the like. However, the arrangement structure of the pixels PXL is not limited thereto, and the pixels PXL may be arranged in the display area DA in one or more suitable structures and/or manners.

In some embodiments, two or more kinds of pixels PXL may emit lights of different colors. In one or more embodiments, the pixel PXL may include a first pixel PXL1 emitting (e.g., configured to emit) light of a first color, a second pixel PXL2 emitting (e.g., configured to emit) light of a second color, and a third pixel PXL3 emitting (e.g., configured to emit) light of a third color. At least one first pixel PXL1, a least one second pixel PXL2, and at least one third pixel PXL3, which are provided adjacent to each other, may constitute one pixel unit capable of emitting lights of various colors. For example, each of the first to third pixels PXL1, PXL2, and PXL3 may be a sub-pixel emitting (e.g., configured to emit) light of a set or predetermined color. In some embodiments, the first pixel PXL1 may be a red pixel emitting light of red, the second pixel PXL2 may be a green pixel emitting light of green, and the third pixel PXL3 may be a blue pixel emitting light of blue. However, embodiments of the present disclosure are not limited thereto.

In one or more embodiments, the first pixel PXL1, the second pixel PXL2, and the third pixel PXL3 may have, as light sources, a light emitting element LD of a first color, a light emitting element LD of a second color, and a light emitting element LD of a third color, to emit light of the first color, the second color, and the third color, respectively. In some embodiments, the first pixel PXL1, the second pixel PXL2, and the third pixel PXL3 have light emitting elements LD emitting light of the same color, and may include color conversion layers and/or color filters of different colors, which are provided on the respective light emitting elements LD, to respectively emit light of the first color, the second color, and the third color. However, the color, kind, and/or number of pixels PXL constituting each pixel unit are not particularly limited. For example, the color of light emitted by each pixel PXL may be variously suitably changed.

In some embodiments, the pixel PXL may include at least one light source driven by a set or predetermined control signal (e.g., a scan signal and a data signal) and/or a predetermined power source (e.g., a first power source and a second power source). In one or more embodiments, each pixel PXL may be configured as an active pixel. However, the kind, structure, and/or driving method of pixels PXL which can be applied to the display device are not particularly limited. For example, each pixel PXL may be configured as a pixel of a passive or active light emitting display device using one or more suitable structures and/or driving methods.

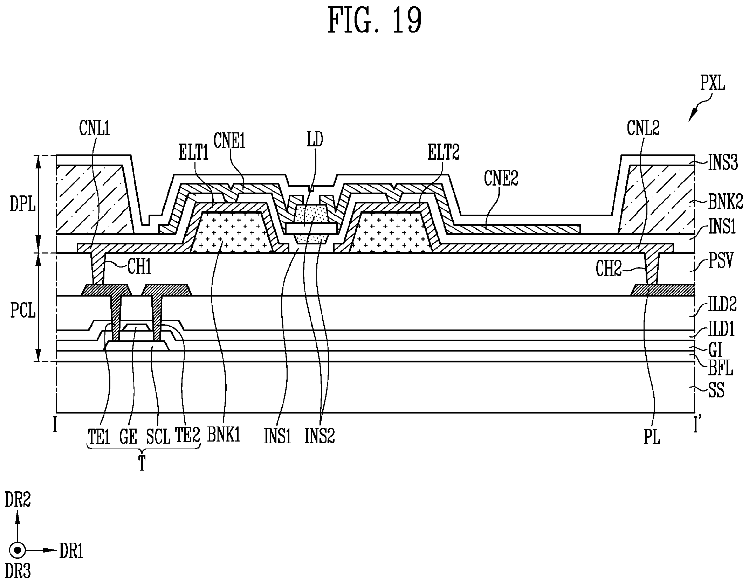

FIG. 19 is a sectional view illustrating one or more embodiments of the pixel included in the display device shown in FIG. 18.

Referring to FIG. 19, a pixel PXL may include a substrate SS, a pixel circuit layer PCL, and a display element layer DPL.

The substrate SS may constitute a base surface of the pixel PXL. The substrate SS may be a rigid or flexible substrate. In one or more embodiments, the substrate SS may include a rigid material and/or a flexible material. However, the material of the substrate SS is not limited to a specific example.

The pixel circuit layer PCL may be provided on the substrate SS. The pixel circuit layer PCL may include a buffer layer BFL, a transistor T, a gate insulating layer GI, a first interlayer insulating layer ILD1, a second interlayer insulating layer ILD2, a first contact hole CH1, a second contact hole CH2, and a protective layer PSV.

The buffer layer BFL may be provided on the substrate SS. The buffer layer BFL may prevent or reduce the diffusion of impurities from the outside. The buffer layer BFL may include at least one selected from among silicon nitride (SiNₓ), silicon oxide (SiOₓ), silicon oxynitride (SiOₓN_{y}), and a metal oxide such as aluminum oxide (AlOₓ).

The transistor T may be a driving transistor. The transistor T may include a semiconductor pattern SCL, a gate electrode GE, a first transistor electrode TE1, and a second transistor electrode TE2.

The semiconductor pattern SCL may be located on the buffer layer BFL. The semiconductor pattern SCL may include at least one selected from among polysilicon, amorphous silicon, and an oxide semiconductor.

The semiconductor pattern SCL may include a first contact region in contact with the first transistor electrode TE1 and a second contact region in contact with the second transistor electrode TE2. The first contact region and the second contact region may correspond to a semiconductor pattern doped with an impurity. A region between the first contact region and the second contact region may be a channel region. The channel region may correspond to an intrinsic semiconductor pattern undoped with the impurity.

The gate insulating layer GI may be provided over the semiconductor pattern SCL. The gate insulating layer GI may include an inorganic material. In one or more embodiments, the gate insulating layer GI may include at least one selected from among silicon nitride (SiNₓ), silicon oxide (SiOₓ), silicon oxynitride (SiOₓN_{y}), and aluminum oxide (AlOₓ). In some embodiments, the gate insulating layer GI may include an organic material.

The gate electrode GE may be located on the gate insulating layer Gl. The position of the gate electrode GE may correspond to the position of the channel region of the semiconductor pattern SCL. For example, the gate electrode GE may be provided on the channel region of the semiconductor pattern SCL with the gate insulating layer GI interposed therebetween.

The first interlayer insulating layer ILD1 may be located over the gate electrode GE. The first interlayer insulating layer ILD1 may include an inorganic material.

The first transistor electrode TE1 and the second transistor electrode TE2 may be located on the first interlayer insulating layer ILD1. The first transistor electrode TE1 may be in contact with the first contact region of the semiconductor pattern SCL while penetrating the gate insulating layer GI and the first interlayer insulating layer ILD1, and the second transistor electrode TE2 may be in contact with the second contact region of the semiconductor pattern SCL while penetrating the gate insulating layer GI and the first interlayer insulating layer ILD1. The first transistor electrode TE1 may be electrically connected to a first connection line CNL1 through the first contact hole CH1 penetrating the protective layer PSV. In one or more embodiments, the first transistor electrode TE1 may be a source electrode, and the second transistor electrode TE2 may be a drain electrode.

The second interlayer insulating layer ILD2 may be located over the first transistor electrode TE1 and the second transistor electrode TE2. Like the first interlayer insulating layer ILD1 and the gate insulating layer GI, the second interlayer insulating layer ILD2 may include an inorganic material. The inorganic material may include at least one of the materials exemplified as the material constituting the first interlayer insulating layer ILD1 and the gate insulating layer GI, e.g., silicon nitride (SiNₓ), silicon oxide (SiOₓ), silicon oxynitride (SiOₓN_{y}), and/or aluminum oxide (AlOₓ). In some embodiments, the second interlayer insulating layer ILD2 may include an organic material.

A power line PL may be provided on the second interlayer insulating layer ILD2. The power line PL may be electrically connected to a second connection line CNL2 through the second contact hole CH2 penetrating the protective layer PSV. Power may be supplied to the power line PL, and the supplied power may be provided to the second connection line CNL2 through the second contact hole CH2.

The protective layer PSV may be located on the second interlayer insulating layer ILD2. The protective layer PSV may cover the power line PL. The protective layer PSV may be provided in a form including an organic insulating layer, an inorganic insulating layer, or the organic insulating layer provided on the inorganic insulating layer.

The display element layer DPL may include a first bank BNK1, a first electrode ELT1, a second electrode ELT2, a first insulating layer INS1, a light emitting element LD, a first contact electrode CNE1, a second contact electrode CNE2, a second insulating layer INS2, a second bank BNK2, and a third insulating layer INS3.

The first bank BNK1 may have a shape protruding in an upper direction, and the first electrode ELT1 and the second electrode ELT2 may be arranged over the first bank BNK1, to form a reflective partition wall. The reflective wall is formed, so that the light efficiency of the light emitting element LD can be improved.

A portion of the first electrode ELT1 may be arranged on the protective layer PSV, and another portion of the first electrode ELT1 may be arranged over the first bank BNK1. The first electrode ELT1 may be a path through which electrical information on the light emitting element LD, which is applied (e.g., supplied) through the first connection line CNL1, can be provided. A portion of the second electrode ELT2 may be arranged on the protective layer PSV, and another portion of the second electrode ELT2 may be arranged over the first bank BNK1. The second electrode ELT2 may be a path through which electrical information on the light emitting element LD, which is applied (e.g., supplied) through the second connection line CNL2, can be provided.

The first insulating layer INS1 may be located on the protective layer PSV. The first insulating layer INS1 may include at least one selected from among silicon nitride (SiNₓ), silicon oxide (SiOₓ), silicon oxynitride (SiOₓN_{y}), and aluminum oxide (AlOₓ).

At least a portion of the first insulating layer INS1 may be provided over the first electrode ELT1 and/or the second electrode ELT2, to stabilize (or substantially stabilize) electrical connection and to reduce external influence.

The light emitting element LD may be located on the first insulating layer INS1. In one or more embodiments, the first insulating layer INS1 may have a set or predetermined groove, at least a portion of the light emitting element LD may be in contact with an end portion (e.g., a step) formed due to the groove, and another portion of the light emitting element LD may be in contact with another end portion (e.g., another step) formed due to the groove.

The light emitting element LD may be located on the first insulating layer INS1 between the first electrode ELT1 and the second electrode ELT2. The light emitting element LD may be the light emitting element LD described above with reference to FIGS. 1 and 2.

The second insulating layer INS2 may be located on the light emitting element LD. The second insulating layer INS2 may be formed to cover an area corresponding to an active layer of the light emitting element LD. The second insulating layer INS2 may include at least one selected from among an organic material and an inorganic material.

In accordance with one or more embodiments, at least a portion of the second insulating layer INS2 may be located on a back surface of the light emitting element LD. The second insulating layer INS2 formed on the back surface of the light emitting element LD may fill an empty gap between the first insulating layer INS1 and the light emitting element LD in a process of forming the second insulating layer INS2 on the light emitting element LD.

The first contact electrode CNE1 and the second contact electrode CNE2 may be provided on the first insulating layer INS1. The first contact electrode CNE1 and the second contact electrode CNE2 may be electrically connected to the first electrode ELT1 and the second electrode ELT2 through contact holes formed in the first insulating layer INS1, respectively.

In accordance with one or more embodiments, the first contact electrode CNE1 and the second contact electrode CNE2 may include a transparent conductive material. In one or more embodiments, the first contact electrode CNE1 may include at least one of conductive materials including Indium Tin Oxide (ITO), Indium Zinc Oxide (IZO), and/or Indium Tin Zinc Oxide (ITZO).

In accordance with one or more embodiments, an electrical signal provided through the first electrode ELT1 may be provided to the light emitting element LD through the first contact electrode CNE1, and the light emitting element LD may emit light, based on the provided electrical signal. An electrical signal provided through the second electrode ELT2 may be provided to the light emitting element LD through the second contact electrode CNE2.

The second bank BNK2 may be a structure defining an emission area of the pixel PXL. The emission area may mean an area in which light is emitted from the light emitting element LD. For example, the second bank BNK2 may be provided at a boundary between adjacent pixels PXL.

The third insulating layer INS3 may be arranged over the second bank BNK2, the first contact electrode CNE1, the second contact electrode CNE2, and the second insulating layer INS2. The third insulating layer INS3 may include any one of an organic material or an inorganic material. The third insulating layer INS3 may protect the display element layer DPL from external influence.

The arrangement relationship associated with the light emitting element, electrode components, and/or the like is not limited to the example described above with reference to FIG. 19, and arrangement relationships in accordance with various modifiable suitable embodiments may be implemented.

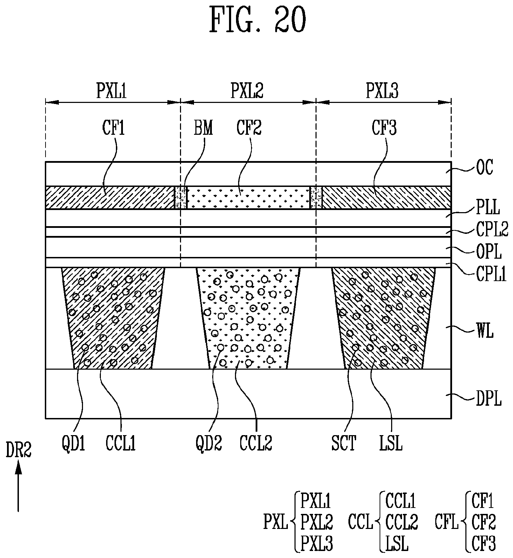

FIG. 20 is a sectional view illustrating the first to third pixels included in the display device shown in FIG. 18.

FIG. 20 illustrates a partition wall WL, a color conversion layer CCL, an optical layer OPL, and a color filter layer CFL, which may be provided on the display element layer DPL of the pixel PXL shown in FIG. 18.

Referring to FIG. 20, the partition wall WL may be provided on the display element layer DPL of the first to third pixels PXL1, PXL2, and PXL3. In one or more embodiments, the partition wall WL may be provided between the first to third pixels PXL1, PXL2, and PXL3 and/or at a boundary between the first to third pixels PXL1, PXL2, and PXL3, and may include an opening overlapping with each of the first to third pixels PXL1, PXL2, and PXL3. The opening of the partition wall WL may provide a space in which the color conversion layer CCL can be provided.

The partition wall WL may include an organic material such as acrylic resin, epoxy resin, phenolic resin, polyamide resin, polyimide resin, polyester resin, polyphenylene sulfide resin, and/or benzocyclobutene (BCB). However, embodiments of the present disclosure are not necessarily limited thereto, and the partition wall WL may include one or more suitable kinds of inorganic insulating materials, including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and/or titanium oxide (TiOₓ).

In some embodiments, the partition wall WL may include at least one light blocking and/or reflective material. Accordingly, light leakage between adjacent pixels PXL can be prevented or reduced. For example, the partition wall WL may include at least one black matrix material and/or at least one color filter material. In one or more embodiments, the partition wall WL may be formed as a black opaque pattern capable of blocking or reducing transmission of light. In one or more embodiments, a reflective layer and/or the like may be formed on a surface (e.g., a sidewall) of the partition wall WL so as to improve the light efficiency of each pixel PXL.

The color conversion layer CCL may be provided on the display element layer DPL including the light emitting elements LD, in the opening(s) of the partition wall WL. The color conversion layer CCL may include a first color conversion layer CCL1 provided in the first pixel PXL1, a second color conversion layer CCL2 provided in the second pixel PXL2, and a light scattering layer LSL provided in the third pixel PXL3.

In one or more embodiments, the first to third pixels PXL1, PXL2, and PXL3 may include light emitting elements LD for emitting light of the same color. For example, the first to third pixels PXL1, PXL2, and PXL3 may include light emitting elements LD emitting light of a third color (or blue). The color conversion layer CCL including color conversion particles is provided on each of the first to third pixels PXL1, PXL2, and PXL3, so that a full-color image can be displayed.

The first color conversion layer CCL1 may include first color conversion particles for converting light of the third color, which is emitted from the light emitting element LD, into light of a first color. For example, the first color conversion layer CCL1 may include a plurality of first quantum dots QD1 dispersed in a set or predetermined matrix material such as base resin.

When the light emitting element LD is a blue light emitting element emitting light of blue, and the first pixel PXL1 is a red pixel, the first color conversion layer CCL1 may include a first quantum dot QD1 for converting light of blue, which is emitted from the blue light emitting element, into light of red. The first quantum dot QD1 may absorb blue light and emit red light by shifting a wavelength of the blue light according to energy transition. In embodiments in which the first pixel PXL1 is a pixel of another color, the first color conversion layer CCL1 may include a first quantum dot QD1 corresponding to the color of the first pixel PXL1.

The second color conversion layer CCL2 may include second color conversion particles for converting light of the third color, which is emitted from the light emitting element LD, into light of a second color. For example, the second color conversion layer CCL2 may include a plurality of second quantum dots QD2 dispersed in a set or predetermined matrix material such as base resin.

When the light emitting element LD is a blue light emitting element emitting light of blue, and the second pixel PXL2 is a green pixel, the second color conversion layer CCL2 may include a second quantum dot QD2 for converting light of blue, which is emitted from the blue light emitting element, into light of green. The second quantum dot QD2 may absorb blue light and emit green light by shifting a wavelength of the blue light according to energy transition. In embodiments in which the second pixel PXL2 is a pixel of another color, the second color conversion layer CCL2 may include a second quantum dot QD2 corresponding to the color of the second pixel PXL2.

Light of blue having a relatively short wavelength in a visible light band is incident into the first quantum dot QD1 and the second quantum dot QD2, so that absorption coefficients of the first quantum dot QD1 and the second quantum dot QD2 can be increased. Accordingly, the efficiency of light finally emitted from the first pixel PXL1 and the second pixel PXL2 can be improved, and excellent or improved color reproduction can be ensured. In addition, the light emitting unit of each of the first to third pixels PXL1, PXL2, and PXL3 is configured by using light emitting elements of the same color (e.g., blue light emitting elements), so that the manufacturing efficiency of the display device can be improved.

The light scattering layer LSL may be provided to efficiently or suitably use light of the third color (or blue) emitted from the light emitting element LD. In one or more embodiments, when the light emitting element LD is a blue light emitting element emitting light of blue, and the third pixel PXL3 is a blue pixel, the light scattering layer LSL may include at least one kind of light scattering particles SCT to efficiently or suitably use light emitted from the light emitting element LD.

For example, the light scattering layer LSL may include a plurality of light scattering particles SCT dispersed in a set or predetermined matrix material such as base resin. In one or more embodiments, the light scattering layer LSL may include a light scattering particle SCT such as silica, but the material constituting the light scattering particles SCT is not limited thereto. However, the light scattering particles SCT may not be provided in only the third pixel PXL3, and may be selectively included even at the inside of the first color conversion layer CCL1 and/or the second color conversion layer CCL2. In some embodiments, the light scattering particle may not be provided (e.g., may be omitted), and the light scattering layer LSL configured with transparent polymer may be provided.

A first capping layer CPL1 may be provided over the color conversion layer CCL. The first capping layer CPL1 may be provided through (e.g., over) the first to third pixels PXL1, PXL2, and PXL3. The first capping layer CPL1 may cover the color conversion layer CCL. The first capping layer CPL1 may prevent or reduce damage to the color conversion layer CCL and/or contamination due to infiltration of an impurity such as moisture and/or air from the outside.

The first capping layer CPL1 is an inorganic layer and may include an inorganic material.

The optical layer OPL may be provided on the first capping layer CPL1. The optical layer OPL may function to improve light extraction efficiency by recycling light provided from the color conversion layer CCL through total reflection. To this end, the optical layer OPL may have a refractive index relatively lower than a refractive index of the color conversion layer CCL. For example, the refractive index of the color conversion layer may be about 1.6 to about 2.0, and the refractive index of the optical layer OPL may be about 1.1 to about 1.3.

A second capping layer CPL2 may be provided on the optical layer OPL. The second capping layer CPL2 may be provided through (e.g., over) the first to third pixels PXL1, PXL2, and PXL3. The second capping layer CPL2 may cover the optical layer OPL. The second capping layer CPL2 may prevent or reduce damage to the optical layer OPL and/or contamination due to infiltration of an impurity such as moisture and/or air from the outside.

The second capping layer CPL2 is an inorganic layer, and may include silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), silicon oxynitride (SiOₓN_{y}), and/or the like.

A planarization layer PLL may be provided on the second capping layer CPL2. The planarization layer PLL may be provided throughout (e.g., over) the first to third pixels PXL1, PXL2, and PXL3.

The planarization layer PLL may include an organic material. However, embodiments of the present disclosure are not necessarily limited thereto, and the planarization layer PLL may include an inorganic material.

The color filter layer CFL may be provided on the planarization layer PLL. The color filter layer CFL may include color filters CF1, CF2, and CF3 which accord with a color of each pixel PXL. The color filters CF1, CF2, and CF3 which accord with a color of each of the first to third pixels PXL1, PXL2, and PXL3 are provided so that a full-color image can be displayed.

The color filter layer CFL may include a first color filter CF1 provided in the first pixel PXL1 to allow light emitted from the first pixel PXL1 to be selectively transmitted therethrough, a second color filter CF2 provided in the second pixel PXL2 to allow light emitted from the second pixel PXL2 to be selectively transmitted therethrough, and a third color filter CF3 provided in the third pixel PXL3 to allow light emitted from the third pixel PXL3 to be selectively transmitted therethrough.

In one or more embodiments, the first color filter CF1, the second color filter CF2, and the third color filter CF3 may be respectively a red color filter, a green color filter, and a blue color filter, but embodiments of the present disclosure are not necessarily limited thereto. Hereinafter, when any one selected from a color filter among the first color filter CF1, the second color filter CF2, and the third color filter CF3 is designated or when two or more kinds of color filters are inclusively (e.g., collectively) designated, the corresponding color filter or the corresponding color filters are referred to as a "color filter CF" or "color filters CF."

The first color filter CF1 may overlap with the display element layer DPL (and/or the light emitting element LD) and the first color conversion layer CCL in the second direction DR2. The first color filter CF1 may include a color filter material for allowing light of a first color (or red) to be selectively transmitted therethrough. For example, when the first pixel PXL1 is a red pixel, the first color filter CF1 may include a red color filter material.

The second color filter CF2 may overlap with the display element layer DPL (and/or the light emitting element LD) and the second color conversion layer CCL in the second direction DR2. The second color filter CF2 may include a color filter material for allowing light of a second color (or green) to be selectively transmitted therethrough. For example, when the second pixel PXL2 is a green pixel, the second color filter CF2 may include a green color filter material.

The third color filter CF3 may overlap with the display element layer DPL (and/or the light emitting element LD) and the light scattering layer LSL in the second direction DR2. The third color filter CF3 may include a color filter material for allowing light of a third color (or blue) to be selectively transmitted therethrough. For example, when the third pixel PXL3 is a blue pixel, the third color filter CF3 may include a blue color filter material.

A light blocking layer BM may be further provided between the first to third color filters CF1, CF2, and CF3 and/or at a boundary between the first to third color filters CF1, CF2, and CF3. As described above, when the light blocking layer BM is formed between the first to third color filters CF1, CF2, and CF3, a color mixture defect viewed (e.g., that can be seen) at the front and/or side of the display device can be prevented or reduced. The material of the light blocking layer BM is not particularly limited, and the light blocking layer BM may be configured with one or more suitable light blocking materials. In one or more embodiments, the light blocking layer BM may be implemented by stacking the first to third color filters CF1, CF2, and CF3.

An overcoat layer OC may be provided on the color filter layer CFL. The overcoat layer OC may be provided throughout (e.g., over) the first to third pixels PXL1, PXL2, and PXL3. The overcoat layer OC may cover a lower member including the color filter layer CFL. The overcoat layer OC may prevent or reduce the infiltration of moisture and/or air into the above-described lower member. Also, the overcoat layer OC may protect the above-described lower member from a foreign matter such as dust.

The overcoat layer OC may include an organic material. However, embodiments of the present disclosure are not necessarily limited thereto, and the overcoat layer OC may include one or more suitable kinds of inorganic materials.

As discussed, embodiments can provide a light emitting element comprising: a first semiconductor layer; an active layer on the first semiconductor layer; a second semiconductor layer on the active layer, the first semiconductor layer, the active layer, and the second semiconductor layer being sequentially provided in a first direction; and an insulative film around at least a portion of the first semiconductor layer, the active layer, and the second semiconductor layer, wherein the active layer comprises a first barrier layer, a first well layer, and a second barrier layer, which are sequentially provided in the first direction, and wherein the first well layer comprises first holes penetrating the first well layer.

The first holes may be etching holes. The plurality of etching holes may penetrate the well layer in the first direction. The first holes may extend from a first surface to a second surface (e.g. upper surface to lower surface) of the first well layer, to completely penetrate the first well layer. Hence, the first holes may completely penetrate the first well layer.

Material from the second barrier layer may fill the first holes.

Each of the plurality of first etching holes may have a width varying in the first direction. In other words, the size of the first etching holes in a second direction perpendicular to the first direction (i.e. the width) may vary along the first direction. The first etching holes may have a larger width in a central region, and be narrower in the region of the first and second barrier layers.

Electrons injected into the first semiconductor layer and holes injected into the second semiconductor layer are recombined in the first well layer of the active layer, and accordingly, light corresponding to band gap energy of the well layer may be released.

The plurality of first holes may have different widths.

In one or more embodiments, a thickness of the first barrier layer in the first direction may be different from a thickness of the first well layer in the first direction. For example, the thickness of the barrier layer may be thicker (e.g., larger) than the thickness of the well layer.

In one or more embodiments, the first barrier layer and the first well layer may have different compositions a different composition ratios. For example, the first well layer may include at least one selected from among GaN, GaInP, AIGalnP, InGaN, and InGaAsP. The first barrier layer may include at least one selected from among GaN, InGaN, AlGaP, and AlGaAs, with different a composition or a different composition ratio to the first well layer. For example, the first well layer may have an indium (In) composition ratio higher than an indium (In) composition ratio of the first barrier layer. The first and second barrier layers may have the same or different compositions or different composition ratios to each other. The second barrier layer may include at least one selected from among GaN, InGaN, AlGaP, and AlGaAs.

As discussed, the active layer may include first and second barrier layers and a first well layer. The first barrier layer, the first well layer and the second barrier layer may form a quantum well structure. The first barrier layer and the second barrier layer may be formed of one semiconductor material, and the first well layer may be formed of a different semiconductor material.

In some embodiments, the barrier layer may include first, second, third, and fourth barrier layers. The well layer may include first, second, and third well layers.

In one or more embodiments, the active layer may have a multi-layer structure in which the first, second, third, and fourth barrier layers are stacked alternately with the first, second, and third well layers, respectively. In one or more embodiments, the first barrier layer and the second barrier layer may be formed on the first semiconductor layer with the first well layer interposed therebetween. The second barrier layer and the third barrier layer may be formed on the first well layer with the second well layer interposed therebetween. The third barrier layer and the fourth barrier layer may be formed on the second well layer with the third well layer interposed therebetween. Other embodiments may have difference numbers of stacked individual layers forming the well layer (e.g. two, with first and second well layers), with different numbers of barrier layers either side of each individual layer forming the well layer. In such arrangements, each individual layer forming the well layer may include at least one selected from among GaN, GaInP, AIGalnP, InGaN, and InGaAsP, either in the same or different compositions or the same of different composition ratios to each other. Each barrier layer may include at least one selected from among GaN, InGaN, AlGaP, and AlGaAs, with different compositions or different composition ratios to the corresponding individual layers forming the well layer.

In one or more embodiments, the first semiconductor layer may include, for example, at least one n-type semiconductor layer. The first semiconductor layer may include an upper surface in contact with the active layer and a lower surface exposed to the outside along the width direction of the light emitting element. The lower surface of the first semiconductor layer may be one end portion (e.g., bottom end portion) of the light emitting element.

In one or more embodiments, the active layer is formed on the first semiconductor layer, and may be formed in a single or multiple quantum well structure. In one or more embodiments, when the active layer is formed in the multiple quantum well structure, a barrier layer and a well layer, which constitute one unit, may be periodically and repeatedly stacked in the active layer. In one or more embodiments, the barrier layer may further include a strain reinforcing layer. The strain reinforcing layer may have a relatively small lattice constant, to further reinforce strain, e.g., compressive strain applied to the well layer.

In one or more embodiments, the second semiconductor layer is formed on the second surface of the active layer, and may include a semiconductor layer having a type (e.g., a p-type or n-type) different from that of the first semiconductor layer. In one or more embodiments, the second semiconductor layer may include a lower surface in contact with the second surface of the active layer and an upper surface exposed to the outside along the width direction of the light emitting element. The upper surface of the second semiconductor layer may be the other end portion (e.g., top end portion) of the light emitting element.

In one or more embodiments, the light emitting element may further include a contact electrode (hereinafter, referred to as a "first contact electrode") provided on the top of the second semiconductor layer, in addition to the first semiconductor layer, the active layer, and the second semiconductor layer, which are described above. In some embodiments, the light emitting element may further include another contact electrode (hereinafter, referred to as a "second contact electrode") provided at one end of the first semiconductor layer.

The light emitting element may be provided for use in the manufacture of a display, and may have various suitable shapes. In one or more embodiments, the light emitting element may have a rod-like shape, a bar-like shape, a pillar-like shape, and/or the like, which is long in its length direction (e.g., its aspect ratio is greater than 1). In some embodiments, the light emitting element may have a rod-like shape, a bar-like shape, a pillar-like shape, and/or the like, which is short in its length direction (e.g., its aspect ratio is smaller than 1). In some embodiments, the light emitting element may have a rod-like shape, a bar-like shape, a cube-like shape, a pillar-like shape, and/or the like, of which aspect ratio is 1.

As discussed, embodiments can provide a method of manufacturing a light emitting element, the method comprising: sequentially forming a first semiconductor layer, an active layer, and a second semiconductor layer in a first direction on a substrate, wherein the forming of the active layer on the first semiconductor layer comprises: forming a first barrier layer on the first semiconductor layer; forming a well layer on the first barrier layer; partially etching the well layer; and forming a second barrier layer on the well layer.

In the light emitting element, the display device including the same, and the manufacturing method of the light emitting element in accordance with the present disclosure, as etching holes are formed by partially etching a well layer forming an active layer of the light emitting element, a current path formed toward an edge of the well layer can be suppressed (e.g., blocked or reduced). Thus, the movement of electrons injected into the well layer along the edge of the wall layer can be prevented or reduced.

In the light emitting element in accordance with the present disclosure, generation of a leakage current by the electrons moved along the edge of the well layer can be prevented (e.g., suppressed or reduced).

In accordance with the present disclosure, a phenomenon in which the reliability of the light emitting element is deteriorated by the leakage current can be reduced.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the spirit and scope of the present disclosure as set forth in the following claims and their equivalents.

## Claims

**2.** A light emitting element comprising:
a first semiconductor layer;
an active layer on the first semiconductor layer;
a second semiconductor layer on the active layer,
the first semiconductor layer, the active layer, and the second semiconductor layer being sequentially provided in a first direction; and
an insulative film around at least a portion of the first semiconductor layer, the active layer, and the second semiconductor layer,
wherein the active layer comprises a first barrier layer, a first well layer, and a second barrier layer, which are sequentially provided in the first direction, and
wherein the first well layer comprises first holes penetrating the first well layer.

**2.** The light emitting element of claim 1, wherein the first well layer comprises at least one of GaN, GaInP, AIGalnP, InGaN, or InGaAsP;
optionally wherein the first barrier layer and second barrier layer each have a different composition or a different composition ratio to the first well layer;
optionally wherein the first barrier layer and second barrier layer each comprise at least one selected from among GaN, InGaN, AlGaP, and AlGaAs.

**3.** The light emitting element of claim 1 or 2, wherein the first well layer comprises InₓGa₁₋ₓN, and an indium composition X of the first well layer is from 0.05 to 0.4.

**4.** The light emitting element of any one of claims 1 to 3, wherein the first holes penetrate the first well layer in the first direction, and are provided in a second direction intersecting the first direction.

**5.** The light emitting element of claim 4, wherein each of the first holes has a width that varies in the first direction.

**6.** The light emitting element of claim 4 or 5, wherein, when viewed in a plan view, each of the first holes has a shape that is symmetrical in the second direction.

**7.** The light emitting element of any one of claims 4 to 6, wherein, when viewed in a plan view, the first well layer comprises a first area adjacent to a center of the first well layer and a second area adjacent to an edge of the first well layer, and
wherein the first holes are in the second area.

**8.** The light emitting element of any one of claims 1 to 7, wherein the second barrier layer fills spaces formed by the first holes and the first barrier layer.

**9.** The light emitting element of any one of claims 1 to 8, further comprising a second well layer and a third barrier layer, sequentially provided in the first direction on the second barrier layer,
wherein the second well layer comprises second holes penetrating the second well layer in the first direction, and
wherein a number of the first holes and a number of the second holes are different from each other.

**10.** The light emitting element of claim 9, wherein the first well layer and the second well layer comprise at least one of GaN, GaInP, AIGalnP, InGaN, or InGaAsP, and
wherein the first well layer and the second well layer have the same composition and have different composition ratios.

**11.** A method of manufacturing a light emitting element, the method comprising:
sequentially forming a first semiconductor layer, an active layer, and a second semiconductor layer in a first direction on a substrate,
wherein the forming of the active layer on the first semiconductor layer comprises:
forming a first barrier layer on the first semiconductor layer;
forming a well layer on the first barrier layer;
partially etching the well layer; and
forming a second barrier layer on the well layer.

**12.** The method of claim 11, wherein, in the partially etching of the well layer, a plurality of holes are formed by etching, in the first direction, at least one area of the well layer along a second direction intersecting the first direction.

**13.** The method of claim 12, wherein the etching of the at least one area of the well layer in the first direction comprises exposing the at least one area of the well layer to an etching gas.

**14.** The method of claim 13, wherein the well layer is formed at a first temperature, and the first barrier layer and the second barrier layer are formed at a second temperature higher than the first temperature,
wherein, in the exposing of the at least one area of the well layer to the etching gas, the etching gas is exposed to the at least one area of the well layer while temperature of the well layer is increased from the first temperature to the second temperature, and
wherein the etching gas comprises a hydrogen,(H₂, gas.

**15.** The method of claim 13 or 14, wherein a size and a number of the plurality of holes are controlled by at least one of an amount of the etching gas, an exposure time of the etching gas, or a size of the at least one area of the well layer exposed to the etching gas.
